# EUROPEAN PATENT APPLICATION

(11) **EP 2 050 390 A1**
(43) Date of publication of application: **22.04.2009**
(21) Application number: 07791704.5
(22) Date of filing: 31.07.2007
(51) Int. Cl.: A61B 5/055

(54) **MAGNETIC FIELD GENERATOR AND NUCLEAR MAGNETIC RESONANCE DEVICE PROVIDED WITH THIS MAGNETIC FIELD GENERATOR**

(30) Priority: 31.07.2006 JP 2006209214
(71) Applicant: National University Corporation Okayama University, Okayama-shi, Okayama 700-8530 (JP); Hitachi Metals, Ltd., Minato-ku Tokyo 105-8614 (JP)
(72) Inventor: KATO, Hirokazu, 5-1, Shikata-cho, 2-chome Okayama-shi, Okayama 700-8558 (JP); TAKAHASHI, Norio, 1-1, Tsushima-Naka, 3-chome Okayama-shi, Okayama 700-8530 (JP); ASAUMI, Junichi, Okayama-shi Okayama 700-8558 (JP); AOKI, Masaaki, Kishima-gun Saga 849-2102 (JP)
(74) Representative: Bertrand, Didier
(86) International application number: PCT/JP2007/065020
(87) International publication number: WO 2008/016062

(57) **Abstract**

A magnetic field generator includes a magnetic circuit of an open magnetic path in which a uniform magnetic field can be generated with a simpler structure. A nuclear magnetic resonance device equipped with this magnetic field generator is also provided. The magnetic field generator of an open magnetic path type includes: a first permanent magnet and a second permanent magnet which are arranged sequentially in a reference direction with a predetermined distance therebetween while directing the direction of magnetization in the reference direction, and a third permanent magnet and a fourth permanent magnet which are arranged sequentially between the first permanent magnet and the second permanent magnet along the reference direction while being in contact with each other or being spaced apart from each other with a predetermined distance therebetween. The direction of magnetization of the third permanent magnet has a first component parallel to the reference direction and a second component intersecting a first direction orthogonally and directed toward the region side. The direction of magnetization of the fourth permanent magnet has a first component and an inverted second component opposite to the direction of the second component and having a magnitude equal to a magnitude of the second component.

## Description

### Technical Field

The present invention relates to a magnetic field generator and a nuclear magnetic resonance device provided with the magnetic field generator, and more particularly to a magnetic field generator having a magnetic circuit of an open magnetic path in which a plurality of magnetic field generating units is arranged laterally without adopting arrangement in which a plurality of magnetic field generating unit is arranged to face each other.

### Background Art

Conventionally, in a nuclear magnetic resonance device, a region having uniform and stable magnetic flux density is formed using a counter-type magnetic field generator which arranges a permanent magnet of N pole and a permanent magnet of S pole in an opposedly-facing manner with a person who is a subject sandwiched therebetween, and a predetermined inspection is performed.

Accordingly, the magnetic field generator is required to form a relatively large gap which allows the insertion of the subject between the opposedly facing permanent magnets. Due to such constitution, the permanent magnets are required to generate a larger magnetic force and hence, the use of larger-sized permanent magnets becomes necessary thus making the magnetic field generator large-sized and pushing up a manufacturing cost.

Such a nuclear magnetic resonance device is extremely effective in observing the inside of a body of the subject. However, for example, in the observation of a part of the subject which is relatively close to a surface of a body such as an eye, an ear, a nose or a tooth, for example, ability of the nuclear magnetic resonance device exceeds ability necessary for the observation of such a part.

Accordingly, in place of the counter-type magnetic field generator which constitutes a magnetic circuit of a closed magnetic path which arranges the N pole and the S pole in an opposedly facing manner, there has been proposed a magnetic field generator which constitutes a magnetic circuit of an open magnetic path in which an N pole and an S pole are arranged in the lateral direction (see patent document 1, for example).

In such a magnetic field generator, respective one-magnetic-pole sides of two permanent magnets having a rectangular parallelepiped shape are connected to a yoke having a rectangular parallelepiped shape thus forming a so-called U-shaped magnet having a U shape, and an N pole and an S pole are formed on distal ends of the U-shaped magnet thus forming a magnetic circuit of an open magnetic path.

Further, an auxiliary magnet is arranged between an end portion of U-shaped magnet which forms the N pole and the end portion of the U-shaped magnet which forms the S pole thus forming a region where magnetic flux density is set uniform due to an interaction between the auxiliary magnet and the U-shaped magnet.

Further, as another magnetic field generator, there has been proposed a technique in which, without using a U-shaped magnet, a plurality of magnets which respectively has predetermined lengths and directs the respective directions of magnetization in predetermined directions is arranged laterally thus forming a region where the magnetic flux density is set uniform (see non-patent document 1, for example).
[Patent document 1] JP-A-2003-250777
[Non-Patent document 1] The Fundamental Investigation of Optimal Design of Magnetic Circuit for Open Type MRI equipment by Yoshinori Okamoto and others, Denki Gakkai (Institute of Electrical Engineers of Japan), Study Group on Material of Magnetics MAG-04-156, 2004

### Disclosure of the Invention

### Tasks to be solved by the Invention

However, with respect to the magnetic field generator disclosed in JP-A-2003-250777 which constitutes the magnetic circuit of an open-magnetic path using the U-shaped magnet and the auxiliary magnet, a range where a region having the uniform magnetic flux density is formed is small in size and hence, it is difficult to acquire a region having a desired size.

Further, in the magnetic field generator which constitutes the magnetic circuit of an open-magnetic path using the plurality of magnets which makes the respective directions of magnetization different from each other and, at the same time, makes the respective lengths thereof different from each other, the number of kinds of required magnets becomes extremely large and hence, the magnetic field generator is easily influenced by irregularities of performances of the magnets per se thus increasing irregularities of the region having the uniform magnetic flux density generated for every magnetic field generator whereby there arises a drawback that an adjustment operation for suppressing the irregularities of the magnetic flux density is extremely difficult.

Under such circumstances, inventors of the present invention have made researches and developments for providing a magnetic field generator which is constituted of a magnetic circuit of an open-magnetic path which can form a uniform magnetic field having a simpler structure, and have arrived at the present invention.

The present invention is directed to a magnetic field generator of an open magnetic path type which is configured to form a region having magnetic flux density of a uniform magnitude at a predetermined position away from a surface of a casing using a plurality of permanent magnets housed in the casing, the magnetic field generator including a first permanent magnet and a second permanent magnet which direct directions of magnetization in a reference direction opposite to a direction of the magnetic flux density in the region, and are sequentially arranged in the reference direction with a predetermined distance therebetween; and a third permanent magnet and a fourth permanent magnet which are sequentially arranged between the first permanent magnet and the second permanent magnet in a state that the third permanent magnet and the fourth permanent magnet are brought into contact with each other or are arranged with a predetermined distance therebetween along the reference direction, wherein a direction of magnetization of the third permanent magnet is set to a direction having a first component which is directed parallel to the reference direction and a second component which is directed toward the region side orthogonal to the first direction, and a direction of magnetization of the fourth permanent magnet is set to a direction having the first component and an inverted second component having a magnitude equal to a magnitude of the second component in a direction opposite to a direction of the second component.

Further, the magnetic field generator of the present invention is also characterized by following technical features.
(1) The third permanent magnet and the fourth permanent magnet are respectively formed of a permanent magnet which includes a non-magnetic-material region where no magnetic material is present, and is configured to adjust apparent residual magnetic flux density by adjusting a size of the non-magnetic-material region and, thereafter, by magnetizing the magnetic material with saturated residual magnetic flux density by an external magnetic field having a predetermined intensity.
(2) The adjustment of size of the non-magnetic region is the adjustment of at least any one of size, number and depth of holes or slits formed in the permanent magnet.
(3) The adjustment of size of the non-magnetic region is the adjustment of a mixing ratio of a plurality of lump permanent magnets having a sufficiently small size compared to a volume of the third permanent magnet and a volume of the fourth permanent magnet and a non-magnetic material in a permanent magnet which is formed by mixing the plurality of permanent magnets and the non-magnetic material and by forming the lump permanent magnets and the non-magnetic material into an integral body having a predetermined shape.
(4) The adjustment of size of the non-magnetic region is the adjustment of a content ratio of a plurality of permanent magnet blocks and a plurality of non-magnetic-material blocks having the same shape as the permanent magnet blocks in a permanent magnet which is formed by integrally bonding the permanent magnet blocks and the non-magnetic-material blocks.
(5) The first permanent magnet and the second permanent magnet are integrally formed by one cylindrical permanent magnet having a cylindrical shape, two pieces of third permanent magnets and two pieces of fourth permanent magnets are respectively arranged in a hollow center portion of the cylindrical permanent magnet in such a state that said two pieces of the third permanent magnets and said two pieces of said fourth permanent magnets are respectively arranged in a mirror symmetry with respect to a symmetry plane which passes the center of the cylindrical permanent magnet and is parallel to the reference direction, a first inner permanent magnet is mounted on a symmetry surface side of the third permanent magnets respectively, and a first outer permanent magnet is mounted on a side opposite to the first inner permanent magnet with the third permanent magnet sandwiched therebetween respectively, a second inner permanent magnet is mounted on a symmetry surface side of the fourth permanent magnets respectively, and a second outer permanent magnet is mounted on a side opposite to the second inner permanent magnet with the fourth permanent magnet sandwiched therebetween respectively, and a direction of magnetizationof the first inner permanent magnet is directed in the direction of the second component, a direction of magnetization of the first outer permanent magnet is directed in a direction opposite to the direction of the second component, a direction of magnetization of the second inner permanent magnet is directed in a direction opposite to the direction of the second component, and a direction of magnetization of the second outer permanent magnet is directed in a direction of the second component.
(6) A fifth permanent magnet is arranged between the first permanent magnet and the third permanent magnet, and a direction of magnetization of the fifth permanent magnet is directed in a combined direction of a third component parallel to or antiparallel to the reference direction and a fourth component which is directed toward a region side orthogonal to the reference direction, and a sixth permanent magnet is arranged between the second permanent magnet and the fourth permanent magnet, and a direction of magnetization of the sixth permanent magnet is directed in a combined direction of the third component and an inverted fourth component which is directed in a direction opposite to a direction of the fourth component and has the same magnitude as the fourth component.
(7) A fifth permanent magnet which has a direction of magnetization thereof directed in the direction parallel to the second component is arranged between the first permanent magnet and the third permanent magnet, and a sixth permanent magnet which has a direction of magnetization thereof directed in the direction parallel to the inverted second component is arranged between the second permanent magnet and the fourth permanent magnet.
(8) The first permanent magnet and the second permanent magnet are integrally formed by one cylindrical permanent magnet having a cylindrical shape, and
   the third permanent magnet and the fourth permanent magnet are respectively arranged in a hollow center portion of the cylindrical permanent magnet.
(9) The first permanent magnet is constituted of two permanent magnets which are arranged in a mirror symmetry with respect to a symmetry plane parallel to the reference direction, and said two permanent magnets respectively include a magnetization component which is directed in a direction orthogonal to the symmetry plane and toward the symmetry plane, and the second permanent magnet is constituted of two permanent magnets which are arranged in a mirror symmetry with respect to the symmetry plane, and said two permanent magnets respectively include a magnetization component which is directed in a direction orthogonal to the symmetry plane and in a direction opposite to the symmetry plane.
(10) The third permanent magnet is constituted of two permanent magnets which are arranged in a mirror symmetry with respect to a symmetry plane parallel to the reference direction, and said two permanent magnets respectively include a magnetization component which is directed in a direction orthogonal to the symmetry plane and toward the symmetry plane, and the fourth permanent magnet is constituted of two permanent magnets which are arranged in a mirror symmetry with respect to the symmetry plane, and said two permanent magnets respectively include a magnetization component which is directed in a direction orthogonal to the symmetry plane and in a direction opposite to the symmetry plane.

Further, a nuclear magnetic resonance device of the present invention is characterized in that the nuclear magnetic resonance device is provided with the above-mentioned magnetic field generator.

### Advantage of the Invention

According to the magnetic field generator of the present invention, in the magnetic field generator which is configured to form a region having magnetic flux density of a uniform magnitude at a predetermined position away from a surface of a casing using a plurality of permanent magnets housed in the casing, the magnetic field generator includes: a first permanent magnet and a second permanent magnet which direct directions of magnetization in a reference direction opposite to a direction of the magnetic flux density in the region, and are sequentially arranged in the reference direction with a predetermined distance therebetween; and a third permanent magnet and a fourth permanent magnet which are sequentially arranged between the first permanent magnet and the second permanent magnet in a state that the third permanent magnet and the fourth permanent magnet are brought into contact with each other or are arranged with a predetermined distance therebetween along the reference direction, a direction of magnetization of the third permanent magnet is set to a direction having a first component which is directed parallel to the reference direction and a second component which is directed toward the region side orthogonal to the first direction, and a direction of magnetization of the fourth permanent magnet is set to a direction having the first component and an inverted second component having a magnitude equal to a magnitude of the second component in a direction opposite to a direction of the second component. Due to such constitution, it is possible to provide the magnetic field generator constituted of a magnetic circuit of an open-magnetic path which can generate a uniform magnetic field by four permanent magnets.

Further, the third permanent magnet and the fourth permanent magnet are respectively formed of a permanent magnet which includes a non-magnetic-material region where no magnetic material is present, and is configured to adjust apparent residual magnetic flux density by adjusting a size of the non-magnetic-material region and, thereafter, by magnetizing the magnetic material with saturated residual magnetic flux density by an external magnetic field having a predetermined intensity. Due to such constitution, residual magnetic flux densities of the third permanent magnet and the fourth permanent magnet are set to desired residual magnetic flux densities with extremely high accuracy and hence, adj ustment accuracy of the magnetic field by the third permanent magnet and the fourth permanent magnet can be enhanced thus increasing the region having the uniform magnetic field.

Further, by arranging the fifth permanent magnet between the first permanent magnet and the third permanent magnet, and by arranging the sixth permanent magnet between the second permanent magnet and the fourth permanent magnet, it is possible to increase the region having the uniform magnetic field.

Further, the nuclear magnetic resonance device of the present invention uses the magnetic field generator which includes at least four permanent magnets. Due to such constitution, the magnetic field generator can be light-weighted and manufactured at a low cost and, at the same time, it is possible to provide a nuclear magnetic resonance device which can be easily installed and maintained at a low cost.

### Brief Description of the Drawings

Fig. 1 is a schematic longitudinal cross-sectional view of a magnetic field generator of a first embodiment;
Fig. 2 is a view showing magnetic flux density distribution of a magnetic field generated by the magnetic field generator of the first embodiment;
Fig. 3 is a graph showing a state of magnetic flux density along an Z axis at X=0 in Fig. 2;
Fig. 4 is a graph showing a state of magnetic flux density along an X axis in Fig. 2;
Fig. 5 is a graph showing a state of magnetic flux density along the X axis at X=0;
Fig. 6 is an explanatory view of a state of arrangement of respective permanent magnets which becomes a basis of calculation performed in Fig. 5;
Fig. 7 is a graph showing dependency of magnitude of magnetization of a fourth permanent magnet with respect to uniformity of a target region
Fig. 8 is a schematic longitudinal cross-sectional view of a magnetic field generator of a modification of the first embodiment;
Fig. 9 is an end surface view as viewed from a line Y1-Y1 in Fig. 8;
Fig. 10 is an end surface view as viewed from a line Y2-Y2 in Fig. 8;
Fig. 11 is a schematic longitudinal cross-sectional view of a magnetic field generator of a second embodiment;
Fig. 12 is a view showing magnetic flux density distribution of a magnetic field generated by the magnetic field generator of the second embodiment;
Fig. 13 is a graph showing a state of magnetic flux density along a Z axis at X=0 in Fig. 12;
Fig. 14 is a graph showing a state of magnetic flux density along an X axis in Fig. 12;
Fig. 15 is an explanatory view of a state of arrangement of first to sixth permanent magnets in the magnetic field generator of the second embodiment;
Fig. 16 is an explanatory view of a modification of a state of arrangement of first to sixth permanent magnets;
Fig. 17 is an explanatory view of a modification of a state of arrangement of first to sixth permanent magnets;
Fig. 18 is an explanatory view of a modification of a state of arrangement of first to sixth permanent magnets;
Fig. 19 is an explanatory view of a state of magnetization of the third permanent magnet and the fourth permanent magnet of a modification;
Fig. 20 is an explanatory view of a modification of a state of arrangement of first to sixth permanent magnets;
Fig. 21 is an explanatory view of a modification of a state of arrangement of first to sixth permanent magnets;
Fig. 22 is an explanatory view of a modification of a state of arrangement of first to sixth permanent magnets; and
Fig. 23 is a schematic longitudinal cross-sectional view of a magnetic field generator for a nuclear magnetic resonance device provided with a reception coil and a transmission coil.

### Description of the Reference Numerals and Signs

A1: magnetic field generator
A2: magnetic field generator
10: casing
10a: main surface
11: first permanent magnet
12: second permanent magnet
13: third permanent magnet
14: fourth permanent magnet
15: fifth permanent magnet
16: sixth permanent magnet

### Best mode for Carrying out the Invention

A magnetic field generator and a nuclear magnetic resonance device which uses such a magnetic field generator according to the present invention are characterized by the use of a magnetic field generator which is constituted of a magnetic circuit of an open-magnetic path. Particularly, by forming such a magnetic field generator using at least four permanent magnets, the magnetic field generator can be extremely miniaturized and light-weighted.

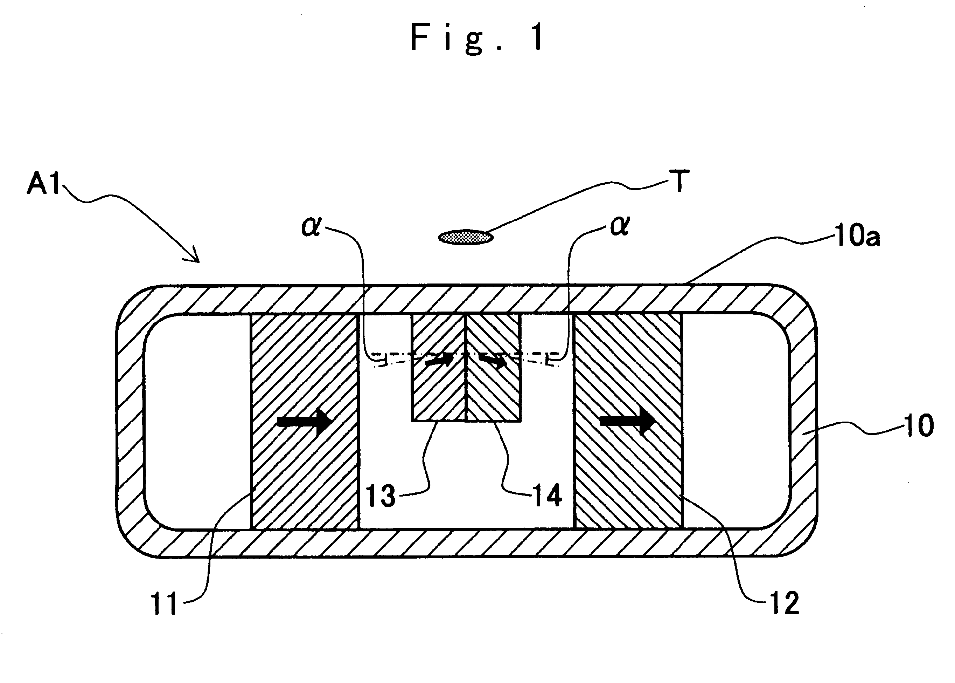

Embodiments of the present invention are explained in detail in conjunction with drawings hereinafter. Fig. 1 is a schematic longitudinal cross-sectional view of a magnetic field generator A1 of the first embodiment. The magnetic field generator A1 is configured such that a first permanent magnet 11 and a second permanent magnet 12 are arranged in one direction with a predetermined distance therebetween in the inside of a casing 10 having a planar main surface 10a on one side surface thereof, and a third permanent magnet 13 and a fourth permanent magnet 14 are arranged between the first permanent magnet 11 and the second permanent magnet 12. Particularly, the third permanent magnet 13 is arranged close to the first permanent magnet 11, and the fourth permanent magnet 14 is arranged close to the second permanent magnet 12. Here, these permanent magnets 11 to 14 are arranged in order of the first permanent magnet 11, the third permanent magnet 13, the fourth permanent magnet 14 and the second permanent magnet 12, and this direction of arrangement of the first to fourth permanent magnets 11 to 14 is set as a reference direction.

Using such first to fourth permanent magnets 11 to 14, the magnetic field generator A1 can form a region having magnetic flux density of uniform magnitude at a position spaced apart from the main surface 10a by a predetermined distance as shown in Fig. 1. The region having magnetic flux density of uniform magnitude is referred to as a target region T. In this target region T, the direction of magnetic flux density is parallel to the main surface 10a and is directed opposite to the reference direction.

In this embodiment, the first to fourth permanent magnets 11 to 14 are formed of rectangular parallelepiped bodies having predetermined sizes respectively, and are arranged such that respective one-end surfaces of the first to fourth permanent magnets 11 to 14 are brought into contact with a surface of the casing 10 opposite to the main surface 10a.

Although not shown in the drawing, plate-shaped ribs are provided in the inside of the casing 10 at predetermined positions for reinforcing the casing 10, and the first to fourth permanent magnets 11 to 14 are held at predetermined positions by adjusting the arrangement of these ribs.

A magnitude of magnetization of the first permanent magnet 11 and a magnitude of magnetization of the second permanent magnet 12 are set equal to each other as described later. Further, a magnitude of magnetization of the third permanent magnet 13 and a magnitude of magnetization of the fourth permanent magnet 14 are also set equal to each other as described later.

The direction of magnetization of the first permanent magnet 11 and the direction of magnetization of the second permanent magnet 12 are respectively set parallel to the reference direction as indicated by arrows in Fig. 1.

Further, the direction of magnetization of the third permanent magnet 13 is, as indicated by an arrow in Fig. 1, directed in the direction which makes a predetermined angle α with respect to the reference direction and, particularly, the third permanent magnet 13 has the direction of magnetization thereof directed toward a main surface 10a side.

Further, the direction of magnetization of the fourth permanent magnet 14 is, as indicated by an arrow in Fig. 1, directed in the direction which makes a predetermined angle α with respect to the reference direction and, particularly, the fourth permanent magnet 14 has the direction of magnetization thereof directed toward a side opposite to the main surface 10a side.

That is, assuming the magnitude of magnetization of the third permanent magnet 13 and the magnitude of magnetization of the fourth permanent magnet 14 as m, the third permanent magnet 13 and the fourth permanent magnet 14 respectively have a first component of a magnitude of mcosα in the reference direction. Further, the third permanent magnet 13 has a second component having a magnitude of msinα in the direction orthogonal to the reference direction and is also directed toward the main surface 10a side, and the fourth permanent magnet 14 has an inverted second component having a magnitude of msinα in the direction orthogonal to the reference direction and is also directed to a side opposite to the main surface 10a side. That is, the third permanent magnet 13 and the fourth permanent magnet 14 have magnetization components of the same magnitude in the directions orthogonal to the reference direction and opposite to each other.

A magnitude of an angle α is set to a proper value by taking a balance between the magnitude of magnetization of the third permanent magnet 13 and the magnitude of magnetization of the fourth permanent magnet 14. By setting the magnitude of magnetization of the third permanent magnet 13 and the magnitude of magnetization of the fourth permanent magnet 14 such that the angle α becomes smaller than 45°, it is possible to increase a size of the region having the uniform magnetic flux density which is generated by the magnetic field generator A1. In the region having uniform magnetic flux density, the direction of the magnetic flux density is set opposite to the reference direction.

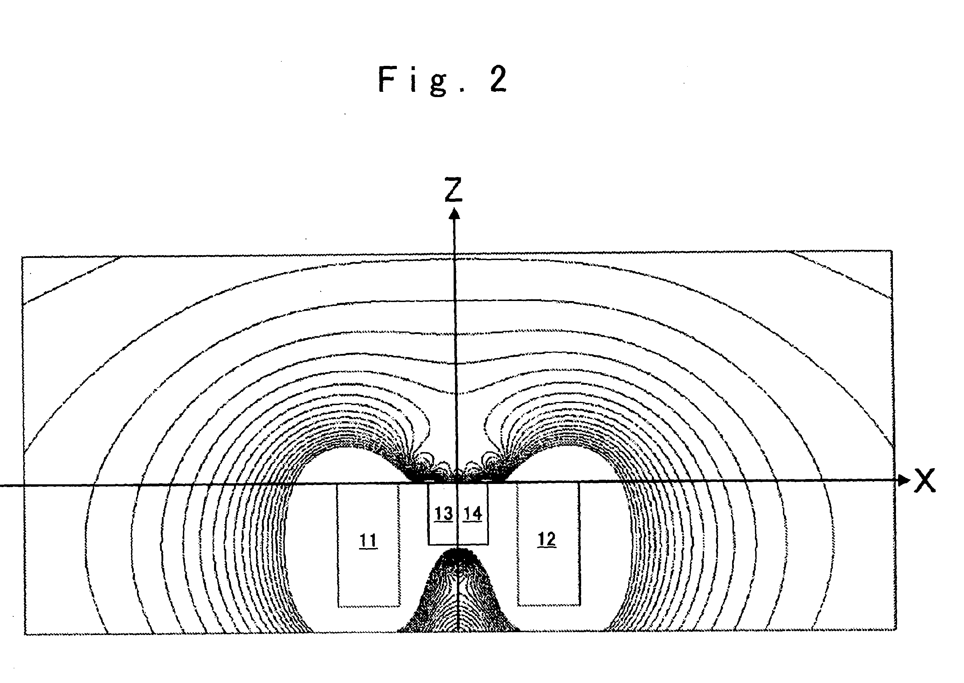

The magnetic field generator A1 having such constitution can form the region having the uniform magnetic flux density at a place which is spaced apart from the main surface 10a by a predetermined distance. It is confirmed that a magnetic field having the magnetic flux density distribution shown in Fig. 2 can be formed based on a numerical value analysis using a model case which is formed with following particulars. As sizes of the first permanent magnet 11 and the second permanent magnet 12, cross sections shown in Fig. 1 are set to 10cmx20cm. As sizes of the third permanent magnet 13 and the fourth permanent magnet 14, cross sections shown in Fig. 1 are set to 5cm×10cm. A distance of approximately 5cm is set between the first permanent magnet 11 and the third permanent magnet 13 as well as between the fourth permanent magnet 14 and the second permanent magnet 12. Residual magnetic flux density of the first permanent magnet 11 and the second permanent magnet 12 is set to 1.38T and residual magnetic flux density of the third permanent magnet 13 and the fourth permanent magnet 14 is set to 1.05T. A magnitude of an angle α is set to 16.5°.

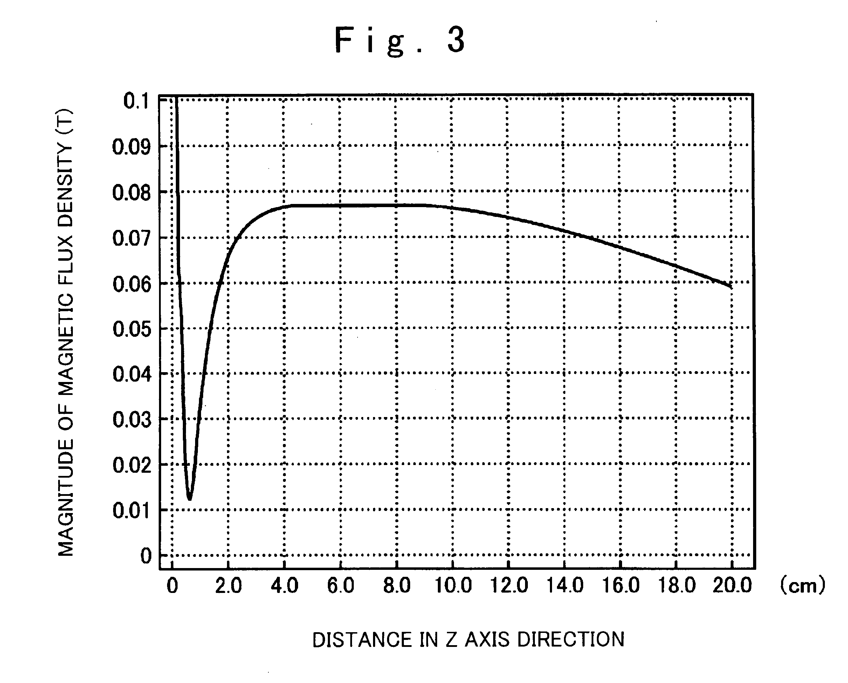

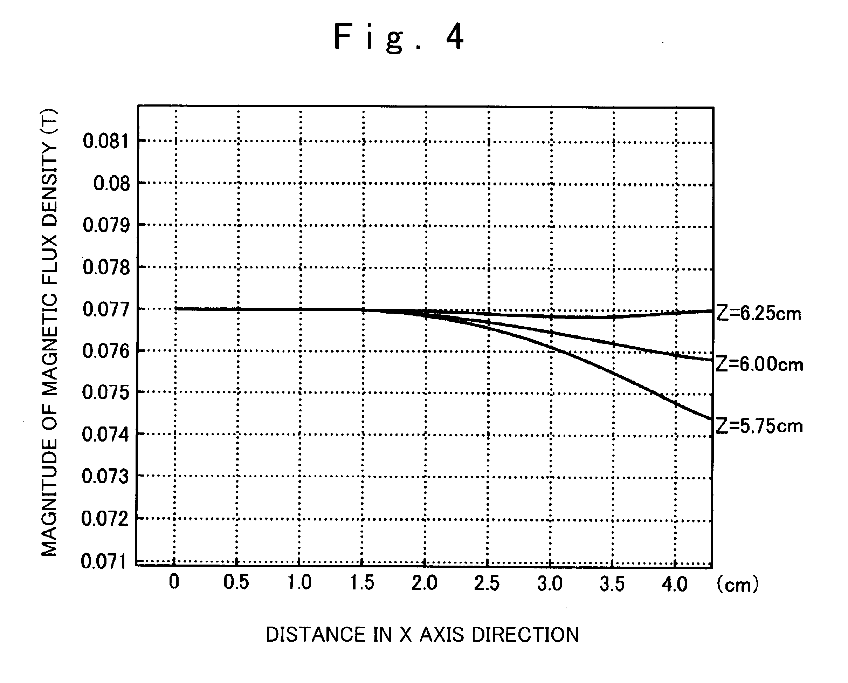

Fig. 3 shows a magnitude of magnetic flux density in the Z axis direction when X=0 in Fig. 2. Fig. 4 shows a magnitude of magnetic flux density in the X axis direction from X=0 when Z=5.75cm, 6.0cm, 6.25cm in Fig. 2. It is understood from Fig. 3 and Fig. 4 that the target region T having uniform magnetic flux density is formed at a position approximately 6cm from the surface of the casing 10 opposite to the main surface 10a which constitutes one end peripheries of the first to forth permanent magnet 11 to 14.

Here, the third permanent magnet 13 and the fourth permanent magnet 14 are arranged in a state that the third permanent magnet 13 and the fourth permanent magnet 14 are brought into contact with each other. However, it is not always necessary to bring these permanent magnets 13, 14 into contact with each other, and these permanent magnets 13, 14 may be arranged in a spaced-apart manner with a predetermined distance therebetween. When these permanent magnets 13, 14 are arranged in a spaced-apart manner, the allowable distance is approximately 3cm. The distance between the third permanent magnet 13 and the fourth permanent magnet 14 may be adjusted by adjusting magnitudes and directions of magnetization of the third permanent magnet 13 and the fourth permanent magnet 14.

Magnitudes of magnetization of the third permanent magnet 13 and the fourth permanent magnet 14 largely influence a size of the region having uniform magnetic flux density and hence, it is desirable to set magnitudes of magnetization of the third permanent magnet 13 and the fourth permanent magnet 14 to predetermined values with high accuracy as much as possible.

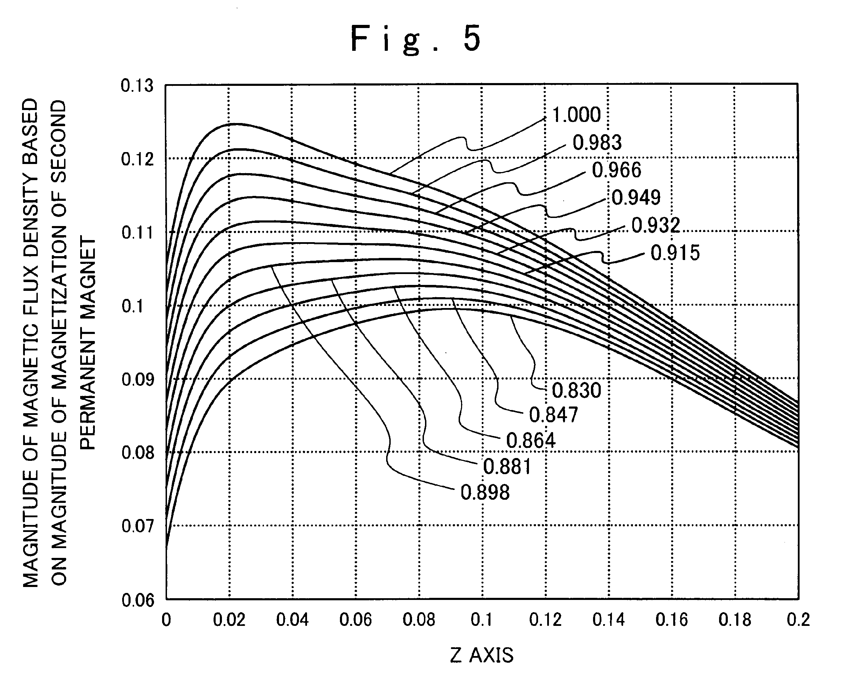

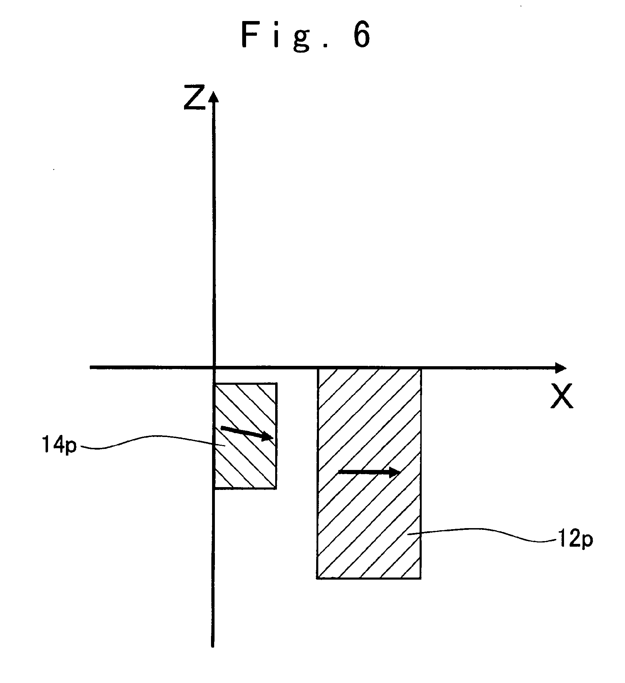

Fig. 5 is a graph showing a result of a test which is performed for checking influence on making magnetic flux density uniform due to the fourth permanent magnet 14 or the third permanent magnet 13. Here, the graph shows a result of calculation of magnitudes of magnetic flux density on the Z axis when Z=0 under conditions shown in Fig. 6. That is, in Fig. 6, the second permanent magnet 12p having a length of 10cm in the X magnetic axis direction and a length of 20cm in the Z axis direction is arranged such that one end periphery of the second permanent magnet 12p is positioned on the X axis 10cm away from an origin of X-Z coordinates, and the fourth permanent magnet 14p having a length of 6cm in the X magnetic axis direction and a length of 10cm in the Z axis direction has one side periphery thereof positioned on the Z axis and has one end periphery thereof arranged from the axis X by a distance of 1.5cm, and the magnitude of magnetization of the fourth permanent magnet 14p is set to values relative to the magnitude of magnetization of the second permanent magnet 12p which becomes the reference, that is, "1.000", "0.983", "0.966", "0.949", "0.932", "0.915", "0.898", "0.881", "0.864", "0.847" and "0.830".

Here, the direction of magnetization of the second permanent magnet 12p is directed in the direction parallel to the reference direction, and the direction of magnetization of the fourth permanent magnet 14p is directed in the direction which sets the above-mentioned angle α to 13°.

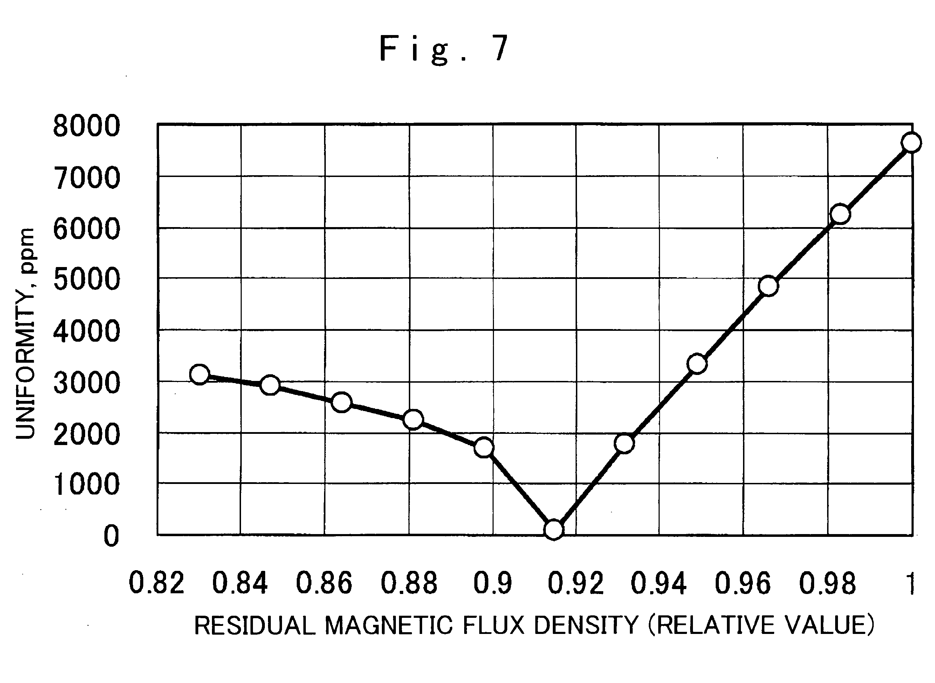

It is apparent from Fig. 5 that the magnitude of magnetization of the fourth permanent magnet 14p influences the size of the region having the uniform magnetic flux density. Further, Fig. 7 is a graph which compares uniformity with respect to a magnitude of relative residual magnetic flux density of the fourth permanent magnet 14p. It is understood from the graph that an optimum value exists with respect to the uniformity. It is understood from the graph that, in this embodiment, it is desirable to set the magnitude of magnetization of the fourth permanent magnet 14p to approximately 0.915 of the magnitude of magnetization of the second permanent magnet 12p. Here, uniformity is a value which is acquired by dividing the difference between a maximum value and a minimum value of magnetic flux density in an estimated region with a value at the center of the target region and by multiplying the divided value with 1×106.

In this manner, the magnitudes of magnetization of the third permanent magnet 13 and the fourth permanent magnet 14 largely influence the enhancement of uniformity of the magnetic flux density in the target region and hence, in the third permanent magnet 13 and the fourth permanent magnet 14, a non-magnetic-material region where a magnetic material is not present is formed, a size of the non-magnetic-material region is adjusted and, thereafter, the magnetic material is magnetized to saturated residual magnetic flux density by an external magnetic field having predetermined intensity thus adjusting apparent residual magnetic flux density.

In a method of adjusting the size of the non-magnetic region, holes or slits are formed in a magnetic-material having a predetermined shape which is not yet magnetized thus forming pores or air gaps which form the non-magnetic regions while maintaining a profile shape of the magnetic-material in a fixed shape, and at least one of a size, the number or a depth of the holes or slits formed in the magnetic-material is suitably adjusted thus adjusting the sizes of the non-magnetic region with high accuracy.

The holes or the slits may be formed by melting a ferro magnetic-material using a wire electric discharge machine or by forming cut grooves using a diamond cutter.

Alternatively, the size of the non-magnetic region of the third permanent magnet 13 or the fourth permanent magnet 14 may be adjusted as follows. That is, a plurality of granular magnetic materials having a lump shape which is sufficiently small compared to a volume of the third permanent magnet 13 or the fourth permanent magnet 14 and a non-magnetic material are mixed to each other, the mixture is formed into an integral body having a predetermined shape, the magnetic materials are magnetized to saturated residual magnetic flux density by an external magnetic field having predetermined intensity thus forming the permanent magnet, and a mixing ratio of the non-magnetic material and the granular magnetic materials is adjusted so as to adjust the size of the non-magnetic region.

As the non-magnetic material used in this embodiment, a non-magnetic resin material can be used. Alternatively, a ceramics material such as silicon dioxide may be used as the non-magnetic material, and such a non-magnetic material may be sintered together with the granular magnetic materials to form an integral body.

In this case, it is desirable that the granular magnetic materials have a sufficiently small size compared to a volume of the third permanent magnet 13 or the fourth permanent magnet 14, and it is also desirable that the size of the granular magnetic materials is smaller than at least one tenth of the volume of the third permanent magnet 13 and the fourth permanent magnet 14. It is more desirable to set the size of the granular magnetic materials to one hundredth or less of the volume of the third permanent magnet 13 and the fourth permanent magnet 14. It is not always necessary to form the granular magnetic materials into a rectangular parallelepiped shape and may be formed in a suitable shape.

Further, when the non-magnetic resin material is used as the non-magnetic material, a predetermined quantity of granular magnetic materials and a predetermined quantity of resin material are mixed to each other, the mixture is filled into a molding vessel which is formed in conformity with a shape of the third permanent magnet 13 or the fourth permanent magnet 14, and the resin is solidified. Thereafter, the magnetic materials are magnetized to the saturated residual magnetic flux density by an external magnetic field having predetermined intensity thus forming the third permanent magnet 13 or the fourth permanent magnet 14 having a predetermined shape. By solidifying the resin before the magnetic materials are magnetized by the external magnetic field having predetermined intensity, it is possible to form the third permanent magnet 13 or the fourth permanent magnet 14 in which the materials which become the permanent magnet are uniformly distributed.

Alternatively, in the adjustment of the size of the non-magnetic region, instead of using the granular magnetic materials and the resin material, a plurality of permanent magnet blocks having a predetermined size and a rectangular parallelepiped shape and a plurality of non-magnetic-material blocks having the same shape as the permanent magnet blocks may be used, and the non-magnetic-material blocks and the permanent magnet blocks may be integrally bonded to each other using an adhesive agent or the like thus forming the third permanent magnet 13 and the fourth permanent magnet 14.

In this case, by adjusting a content ratio between the permanent magnet blocks and the non-magnetic-material blocks, the size of the non-magnetic region can be easily adjusted.

Here, in forming the third permanent magnet 13 or the fourth permanent magnet 14 by integrally bonding the permanent magnet blocks and the non-magnetic-material blocks, the permanent magnet blocks may be preliminarily magnetized to the saturated residual magnetic flux density by an external magnetic field having predetermined intensity or the permanent magnet blocks may be bonded to the non-magnetic-material blocks to be formed into an integral body having a predetermined shape and, thereafter, the integral body may be magnetized to the saturated residual magnetic flux density by an external magnetic field having predetermined intensity. Although the permanent magnet blocks and the non-magnetic-material blocks are formed in a rectangular parallelepiped shape for easing the formation of these blocks in this embodiment, these blocks are not always limited to a rectangular parallelepiped shape, and may be formed in a suitable shape.

In this manner, by forming the non-magnetic-material region where the magnetic material is not present in the third permanent magnet 13 and the fourth permanent magnet 14, and by adjusting the size of the non-magnetic-material region, the apparent residual magnetic flux density of the third permanent magnet 13 and the fourth permanent magnet 14 can be easily adjusted thus forming the third permanent magnet 13 and the fourth permanent magnet 14 having the predetermined residual magnetic flux density with extremely high accuracy. Accordingly, the target region T having the uniform and stable magnetic flux density can be easily formed and, at the same time, the size of the target region T can be easily adjusted.

Further, the third permanent magnet 13 and the fourth permanent magnet 14 are respectively magnetized to the saturated residual magnetic flux density and hence, it is possible to prevent the residual magnetic flux density from being changed due to other permanent magnets such as the first permanent magnet 11 and the second permanent magnet 12.

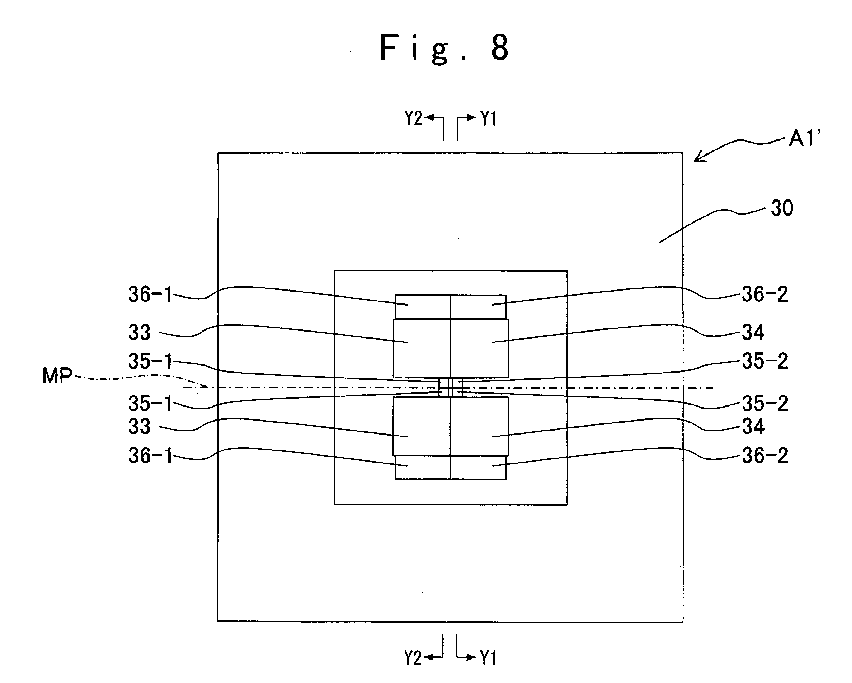

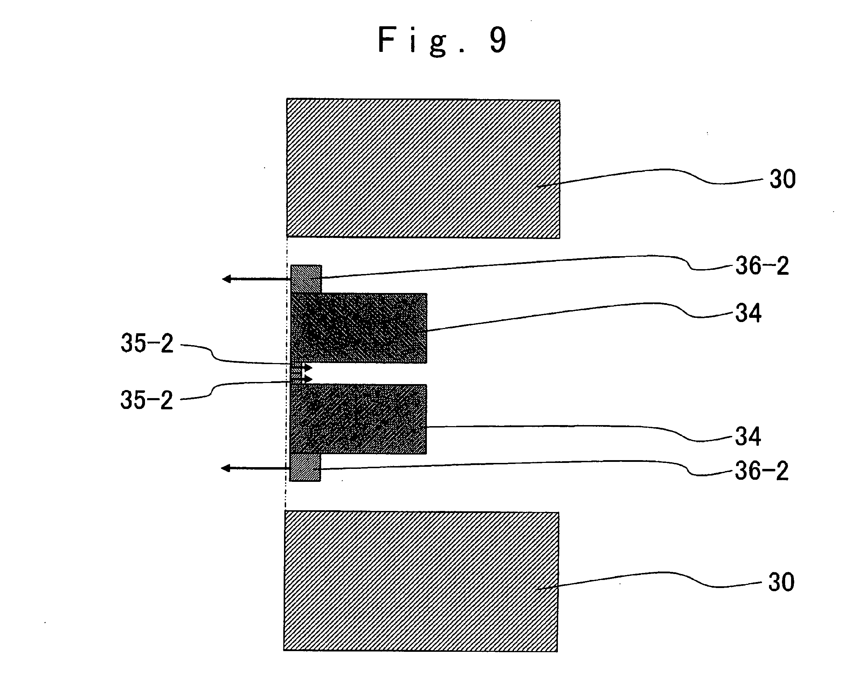

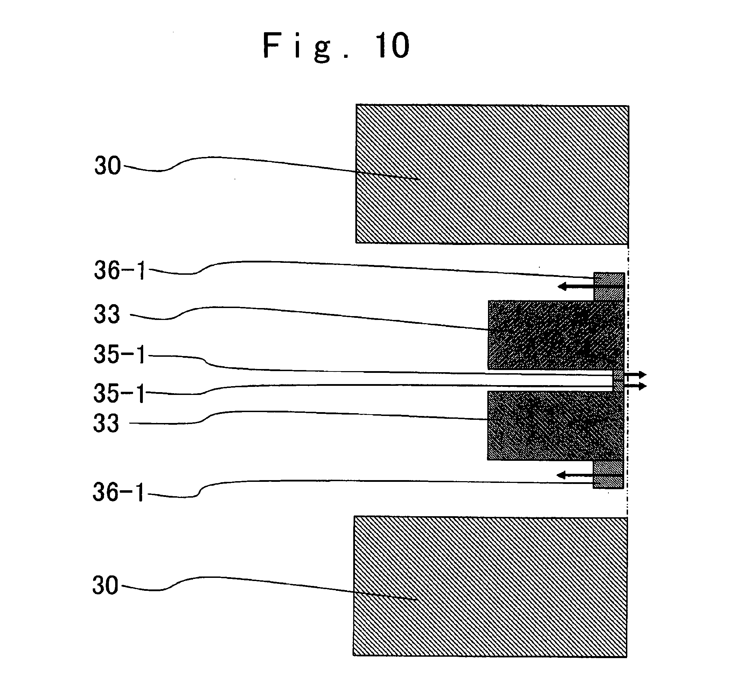

Fig. 8 is a plan view of a magnetic field generator A1' according to a modification of the first embodiment, Fig. 9 is an end surface view as viewed from a line Y1-Y1 in Fig. 8, and Fig. 10 is an end surface view as viewed from a line Y2-Y2 in Fig. 8.

In the magnetic field generator A1' of the modification, in place of the above-mentioned two permanent magnets consisting of the first permanent magnet 11 and the second permanent magnet 12, as shown in Fig. 8, one cylindrical permanent magnet 30 which is formed in an integral cylindrical shape is used. In this cylindrical permanent magnet 30, two third permanent magnets 33, 33 and two fourth permanent magnets 34, 34 are arranged in a hollow center portion.

The cylindrical permanent magnet 30 is magnetized along the reference direction. The direction of magnetization of the third permanent magnet 33 is directed in the direction which makes a predetermined angle α with respect to the reference direction, and particularly directed toward a main surface 10a side. The direction of magnetization of the fourth permanent magnet 34 is directed in the direction which makes a predetermined angle α with respect to the reference direction, and particularly directed toward a side opposite to the main surface 10a side.

Two third permanent magnets 33, 33 are respectively arranged in a mirror symmetry with respect to a symmetry plane MP which passes the center of the cylindrical permanent magnet 30 and is arranged parallel to the reference direction and, at the same time, two fourth permanent magnets 34, 34 are also respectively arranged in a mirror symmetry with respect to the symmetry plane MP which passes the center of the cylindrical permanent magnet 30 and is arranged parallel to the reference direction.

Further, first inner permanent magnets 35-1 are respectively formed on symmetry-plane-MP sides of the third permanent magnets 33 and, at the same time, first outer permanent magnets 36-1 are respectively formed on sides opposite to the first inner permanent magnets 35-1 with the third permanent magnets 33 sandwiched therebetween.

In the same manner, second inner permanent magnets 35-2 are respectively formed on symmetry-plane-MP sides of the fourth permanent magnets 34 and, at the same time, second outer permanent magnets 36-2 are respectively formed on sides opposite to the second inner permanent magnets 35-2 with the fourth permanent magnets 34 sandwiched therebetween.

With respect to the direction of magnetization in the first inner permanent magnets 35-1, the first outer permanent magnets 36-1, the second inner permanent magnets 35-2 and the second outer permanent magnets 36-2, as indicated by arrows in Fig. 9 and Fig. 10, the direction of magnetization is directed in the direction of a second component in the first inner permanent magnets 35-1 and the second outer permanent magnets 36-2, and is directed in the direction opposite to the second component in the first outer permanent magnets 36-1 and second inner permanent magnets 35-2.

In the magnetic field generator A1' having such constitution, uniformity in the depth direction in the target region T can be enhanced thus enhancing the detection accuracy of a stereoscopic object.

To be more specific, the cylindrical permanent magnet 30 is formed in a quadrangular cylindrical shape in which an outer circumference of the permanent magnet 30 has a quadrangular shape with each side thereof set to 40cm and the permanent magnet 30 has a quadrangular opening with each side thereof set to 20cm inside the outer circumference. A size of the cylindrical permanent magnet 30 in the depth direction is set to 20cm.

Sizes of the third permanent magnet 33 and the fourth permanent magnet 34 are respectively set to a longitudinal size of 5cm × a lateral size of 5cm × a depth of 10cm, sizes of the first inner permanent magnets 35-1 and the second inner permanent magnets 35-2 are respectively set to a longitudinal size of 0.8cm × a lateral size of 0.8cm × a depth of 0.8cm, and the sizes of the first outer permanent magnets 36-1 and the second outer permanent magnets 36-2 are respectively set to a longitudinal size of 2cm × a lateral size of 4.8cm × a depth of 2.2cm.

Two first inner permanent magnets 35-1 are arranged adjacent to each other, and may be integrally formed depending on a case. In the same manner, two second inner permanent magnets 35-2 are also arranged adjacent to each other, and may be integrally formed depending on a case. A distance of approximately 4mm is set between the first inner permanent magnets 35-1 and the second inner permanent magnets 35-2 arranged adjacent to each other.

Further, as shown in Fig. 9 and Fig. 10, with respect to the third permanent magnets 33, the fourth permanent magnets 34, the first inner permanent magnets 35-1, the second inner permanent magnets 35-2, the first outer permanent magnets 36-1 and the second outer permanent magnets 36-2 which are arranged in the center portion of the cylindrical permanent magnet 30, an end surface of each permanent magnet on a main surface 10a side of the casing 10 is arranged to be retracted from an end surface of the cylindrical permanent magnet 30 on the main surface 10a side of the casing 10. In this embodiment, the end surface of each permanent magnet on the main surface 10a side of the casing 10 is retracted by approximately 3mm.

The residual magnetic flux density of the cylindrical permanent magnet 30 is set to 1.38T, the residual magnetic flux densities of the third permanent magnets 13 and the fourth permanent magnets 14 are set to 1.30T, the residual magnetic flux densities of the first inner permanent magnets 35-1 and the second inner permanent magnets 35-2 are set to 0.07T, the residual magnetic flux densities of the first outer permanent magnets 36-1 and the second outer permanent magnets 36-2 are set to 0.33T, and a value of the angle α is set to 14.8°.

In this embodiment, the residual magnetic flux densities of the third permanent magnets 13, the fourth permanent magnets 14, the first inner permanent magnets 35-1, the second inner permanent magnets 35-2, the first outer permanent magnet 36-1 and the second outer permanent magnets 36-2 are set to desired apparent residual magnetic flux densities by adjusting the size of the non-magnetic region as described previously.

A following table shows the uniformity (ppm) of magnetic flux densities of estimated regions under the following conditions. That is, the end surface of the cylindrical permanent magnet 30 shown in Fig. 8 on the main surface 10a side of the casing 10 is set as an X-Y plane. Using the center of the cylindrical permanent magnet 30 on the X-Y plane as an origin, an x axis is estimated on the symmetry plane MP, a y axis is estimated orthogonal to the x axis, and a z axis is estimated in the direction toward the target region from the X-Y plane. By setting a position determined by X=0cm, Y=0cm and Z=5.5cm as the center, a range Δx in the X-axis direction, a range Δy in the Y-axis direction, and a range Δz in the Z-axis direction are set to various values.

**Table 1**

| Δx [cm] | Δny [cm] | ΔZ [cm] | uniformity(ppm) |
|---|---|---|---|
| 1.0 | 1.0 | 0.1 | 28 |
| 1.0 | 1.0 | 0.2 | 40 |
| 1.0 | 1.0 | 0.3 | 58 |
| 1.0 | 1.0 | 0.4 | 83 |
| 1.0 | 1.0 | 0.5 | 110 |
| 1.0 | 1.0 | 0.6 | 140 |
| 1.0 | 1.0 | 0.7 | 171 |
| 1.0 | 1.0 | 0.8 | 206 |
| 1.0 | 1.0 | 0.9 | 245 |
| 1.0 | 1.0 | 1.0 | 288 |
| 2.0 | 2.0 | 0.1 | 177 |
| 2.0 | 2.0 | 0.2 | 195 |
| 2.0 | 2.0 | 0.3 | 221 |
| 2.0 | 2.0 | 0.4 | 244 |
| 2.0 | 2.0 | 0.5 | 275 |
| 2.0 | 2.0 | 0.6 | 332 |
| 2.0 | 2.0 | 0.7 | 400 |
| 2.0 | 2.0 | 0.8 | 470 |
| 2.0 | 2.0 | 0.9 | 537 |
| 2.0 | 2.0 | 1.0 | 613 |

It is understood from Table 1 that this embodiment can acquire uniformity which is sufficiently available for the detection of the relatively minute structure such as an eye, an ear, a nose or a teeth.

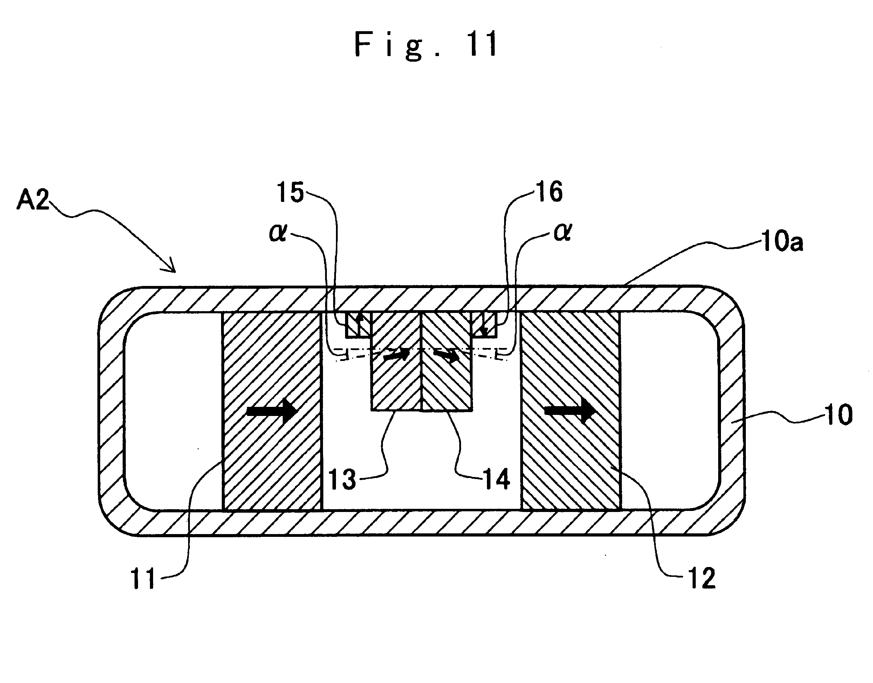

Fig. 11 is a longitudinal cross-sectional view of a magnetic field generator A2 of a second embodiment. This magnetic field generator A2 has the substantially same constitution as the magnetic field generator A1 of the first embodiment, while in this embodiment, a fifth permanent magnet 15 is provided between the first permanent magnet 11 and the third permanent magnet 13 of the magnetic field generator A1 of the first embodiment, and a sixth permanent magnet 16 is provided between the fourth permanent magnet 14 and the second permanent magnet 12 of the magnetic field generator A1 of the first embodiment. Accordingly, constitutional parts identical with the corresponding constitutional parts of the magnetic field generator A1 of the first embodiment are given same symbols and their repeated explanation is omitted.

The fifth permanent magnet 15 and the sixth permanent magnet 16 have the same magnitude of magnetization. Further, the direction of magnetization of the fifth permanent magnet 15 is, as indicated by an arrow in Fig. 11, directed in the direction parallel to the second component of the third permanent magnet 13, and the direction of magnetization of the sixth permanent magnet 16 is, as indicated by an arrow in Fig. 11, directed in the direction parallel to the inversed second component of the fourth permanent magnet 13.

In this manner, by providing the fifth permanent magnet 15 between the first permanent magnet 11 and the third permanent magnet 13 and, at the same time, by providing the sixth permanent magnet 16 between the fourth permanent magnet 14 and the second permanent magnet 12, the uniformity of the magnetic flux density in a target region T generated by the magnetic field generator Δ2 can be enhanced and, at the same time, a size of the target region T can be further increased.

Here, both of magnitudes of magnetization of the fifth permanent magnet 15 and the sixth permanent magnet 16 largely influence the size of the region having the uniform magnetic flux density and hence, it is desirable to set the sizes of these magnetization to predetermined sizes of magnetization with accuracy as high as possible. Accordingly, the size of non-magnetic region is adjusted preliminarily before magnetization such that the desired apparent residual magnetic flux densities can be acquired after magnetization.

Further, in this embodiment, the fifth permanent magnet 15 is arranged to be in contact with the third permanent magnet 13. However, it is not always necessary to arrange the fifth permanent magnet 15 in contact with the third permanent magnet 13. That is, by adjusting the magnitude of magnetization and the direction of the magnetization of the fifth permanent magnet 15, the fifth permanent magnet 15 may be arranged at a suitable position between the first permanent magnet 11 and the third permanent magnet 13.

In the same manner, although the sixth permanent magnet 16 is arranged to be in contact with the fourth permanent magnet 14, it is not always necessary to arrange the sixth permanent magnet 16 in contact with the fourth permanent magnet 14. That is, by adjusting the magnitude of magnetization and the direction of the magnetization of the sixth permanent magnet 16, the sixth permanent magnet 16 may be arranged at a suitable position between the fourth permanent magnet 14 and the second permanent magnet 12.

Particularly, by setting the components of magnetization of the fifth permanent magnet 15 and the sixth permanent magnet 16 in the direction parallel to the reference direction to negative values, that is, by allowing the fifth permanent magnet 15 and the sixth permanent magnet 16 to have the components in the direction antiparallel to the reference direction, uniformity of magnetic flux density in the target region T can be enhanced and, at the same time, the size of the target region T can be further increased.

Alternatively, by setting the components of magnetization of the fifth permanent magnet 15 and the sixth permanent magnet 16 in the direction parallel to the reference direction to positive values, that is, by allowing the fifth permanent magnet 15 and the sixth permanent magnet 16 to have the components in the direction parallel to the reference direction, the size of the target region T can be further increased.

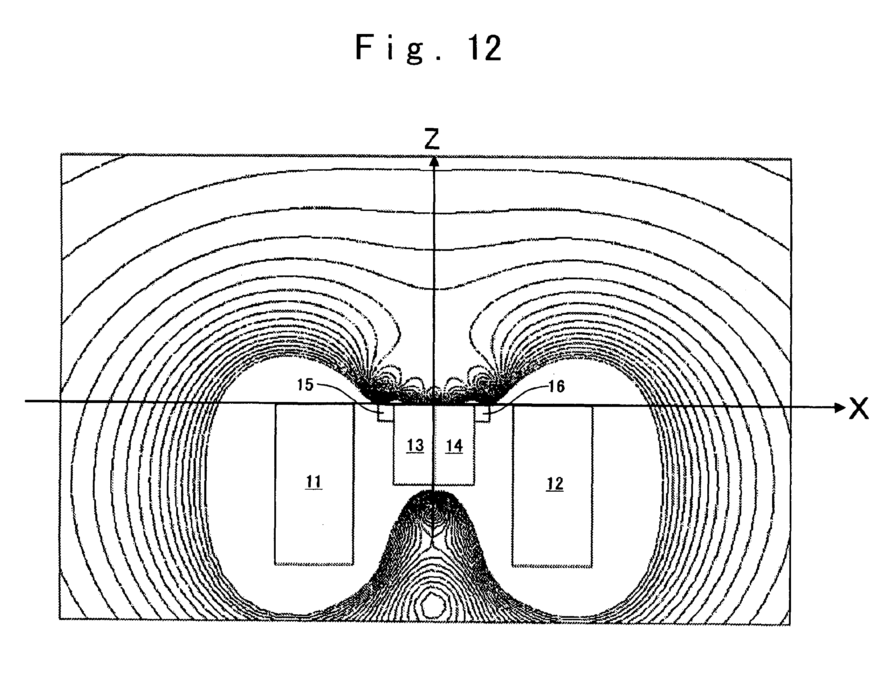

As shown in Fig. 11, in the magnetic field generator A2 in which the direction of magnetization of the fifth permanent magnet 15 is directed in the direction parallel to the second component of the third permanent magnet 13 and the direction of magnetization of the sixth permanent magnet 16 is directed in the direction parallel to the inverted second component of the fourth permanent magnet 14, it is confirmed by a numerical value analysis that a magnetic field having the magnetic flux density distribution in Fig. 12 can be generated. Here, sizes of the first permanent magnet 11 and the second permanent magnet 12 are respectively set to have a cross section of 10cmx20cm shown in Fig. 11, sizes of the third permanent magnet 13 and the fourth permanent magnet 14 are respectively set to have a cross section of 5cm×10cm shown in Fig. 11, and sizes of the fifth permanent magnet 15 and the sixth permanent magnet 16 are respectively set to have a cross section of 2cmx2cm shown in Fig. 8. A distance of approximately 3cm is provided between the first permanent magnet 11 and the fifth permanent magnet 15 as well as between the sixth permanent magnet 16 and the second permanent magnet 12. Residual magnetic flux densities of the first permanent magnet 11 and the second permanent magnet 12 are set to 1.38T, residual magnetic flux densities of the third permanent magnet 13 and the fourth permanent magnet 14 are set to 1.05T, a value of an angle α is set to a value of 16.5°, and residual magnetic flux densities of the fifth permanent magnet 15 and the sixth permanent magnet 16 is set to 0.06T.

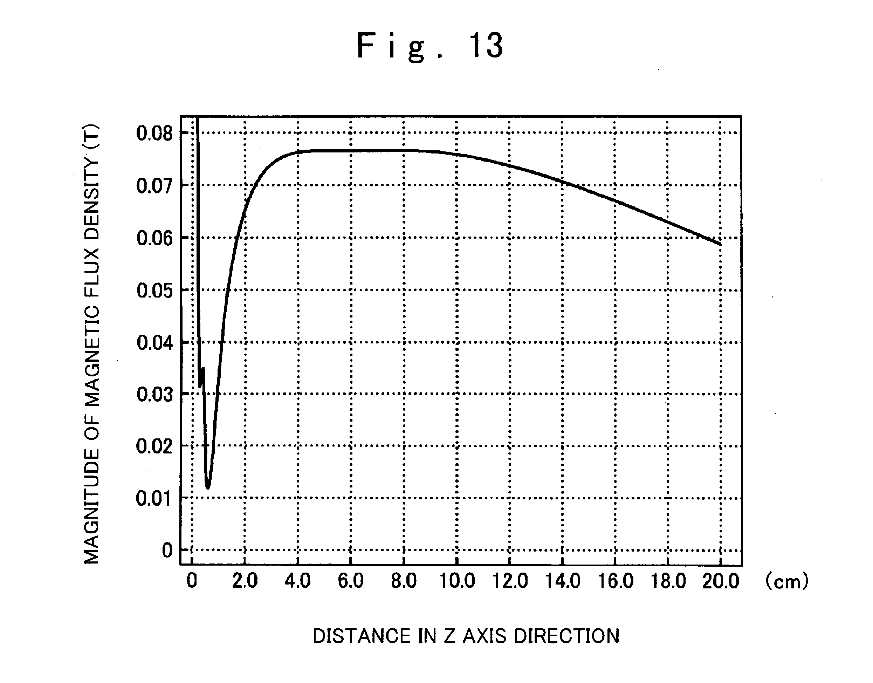

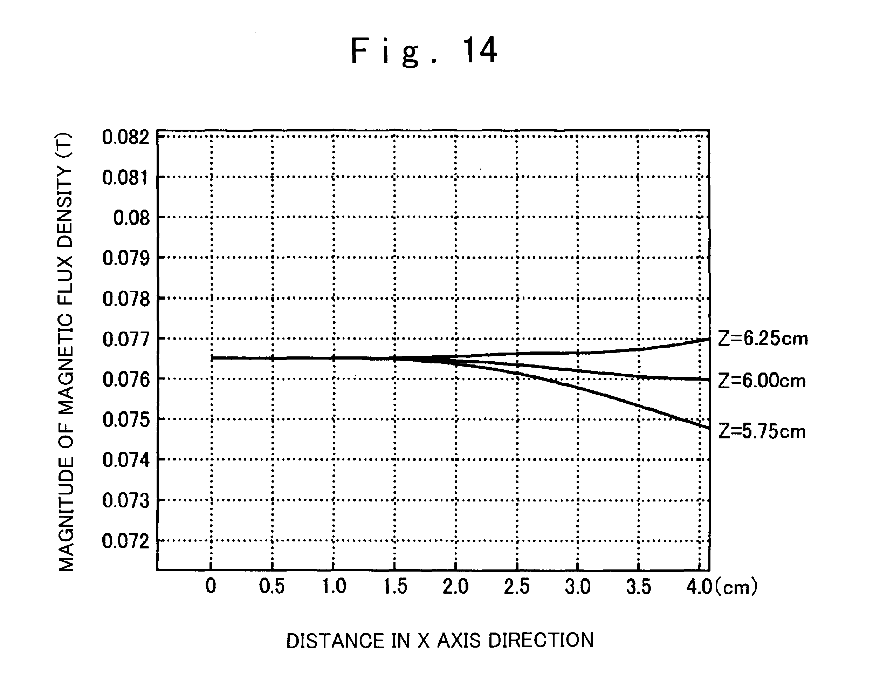

Fig. 13 shows a magnitude of magnetic flux density in the Z axis direction when X=0 in Fig. 12. Fig. 14 shows a magnitude of magnetic flux density in the X axis direction from X=0 when Z=5.75cm, 6.0cm, 6.25cm. It is understood from Fig. 13 and Fig. 14 that the target region T having uniform magnetic flux density is formed at a position approximately 6cm from the surface of the casing 10 opposite to the main surface 10a which constitutes one end peripheries of the first to forth permanent magnet 11 to 14.

Particularly, the uniformity in the target region T where X is set to -1.0cm<X<1.0cm and Z is set to 5.75cm<Z<6.25cmis92ppm. That is, for example,with respect to a region which becomes necessary for realizing the observation of a part such as an eye, an ear, a tooth or the like using a nuclear magnetic resonance device, it is possible to form a region having the uniformity of 100ppm. Such a magnetic field generator A2 and the magnetic field generator A1 of the first embodiment can be used as a magnetic field generator of a nuclear magnetic resonance device.

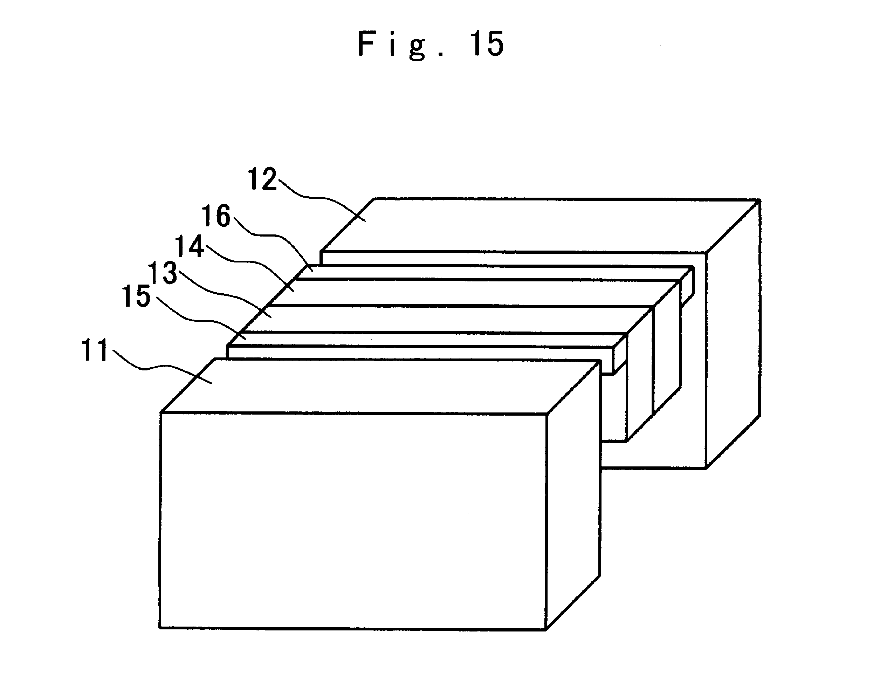

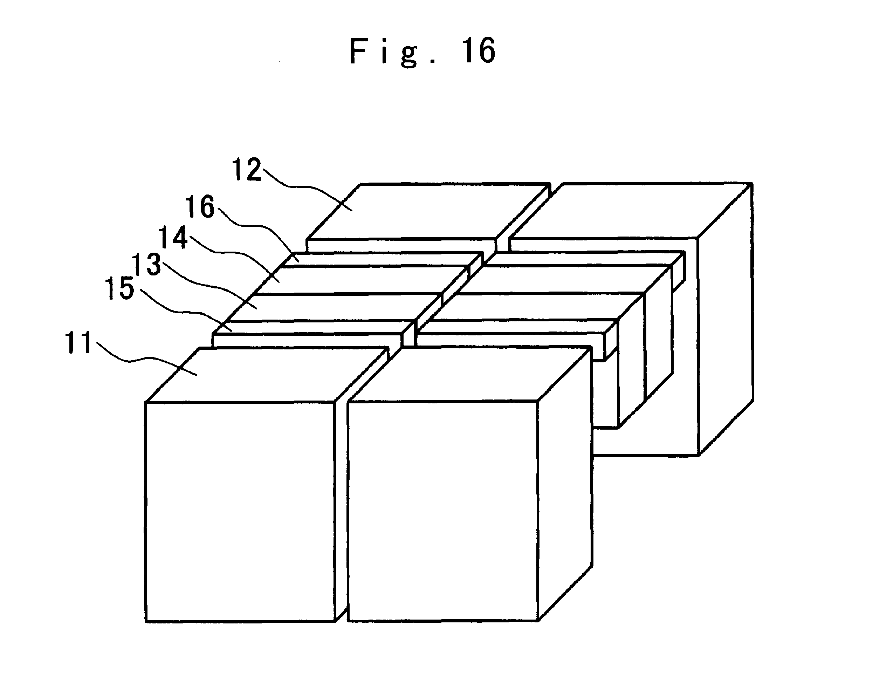

Here, in such a magnetic field generator, the first to sixth permanent magnets 11 to 16 may be, as shown in Fig. 15, formed of permanent magnets elongated in the cross-sectional direction of Fig. 1 and Fig. 11, or the first to sixth permanent magnets 11 to 16 which are respectively set to predetermined lengths may be, as shown in Fig. 16, arranged in series in the longitudinal direction of Fig. 15.

In this manner, according to this magnetic field generator, with the use of the first to sixth permanent magnets 11 to 16 which are elongated in a pseudo manner by forming these magnets in series, non-uniformity of a magnetic field in the longitudinal direction can be eliminated thus generating a uniform magnetic field also in the longitudinal direction.

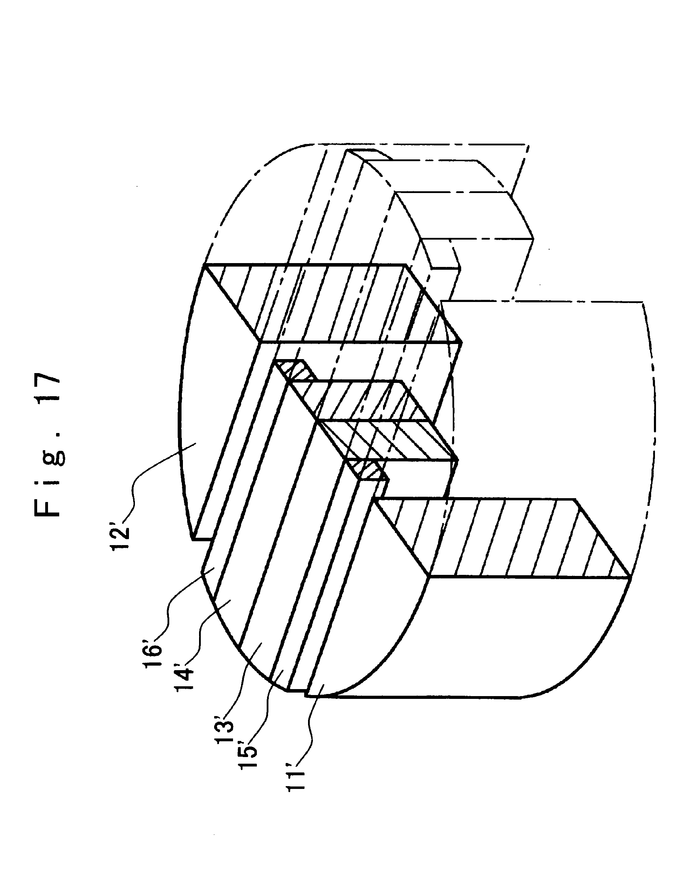

Further, the magnetic field generator may use not only the first to sixth permanent magnets 11 to 16 which are respectively formed in a rectangular parallelepiped shape as viewed in a plan view as shown in Fig. 15 and Fig. 16 but also first to sixth permanent magnets 11' to 16' which are shaped in a circular shape toward the main surface 10a as shown in Fig. 17.

That is, as shown in Fig. 17, the first to sixth permanent magnets 11' to 16' which are arranged in order of the first permanent magnet 11' , the fifth permanent magnet 15', the third permanent magnet 13', the fourth permanent magnet 14', the sixth permanent magnet 16' and the second permanent magnet 12' along the reference direction have side surfaces thereof formed into predetermined curved shapes such that side surfaces of the first to sixth permanent magnets 11' to 16' on a main surface 10a side form a circle as a whole.

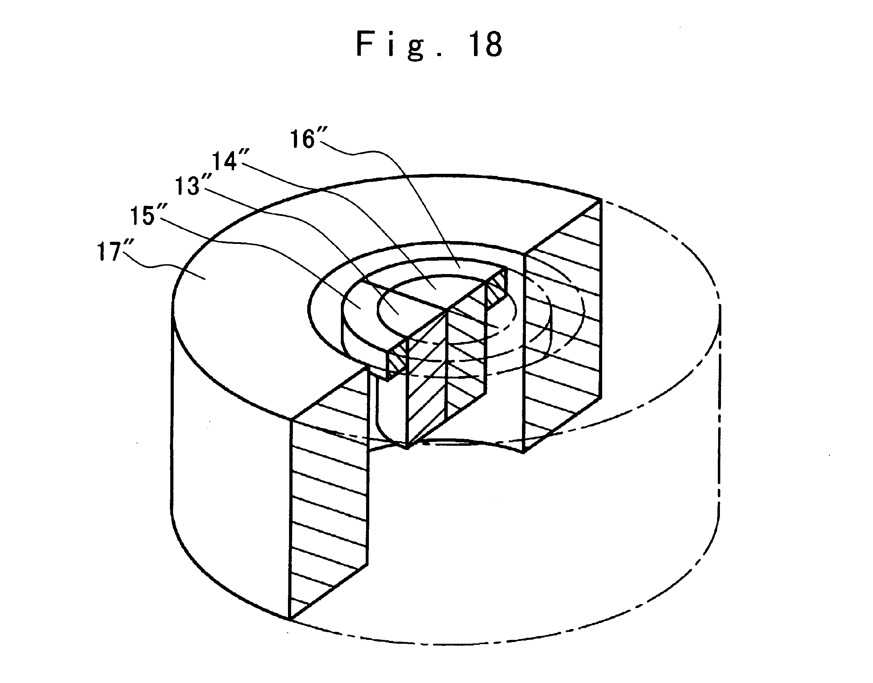

Further, as shown in Fig. 18, in the magnetic field generator, the first permanent magnet 11 and the second permanent magnet may be formed of a cylindrical permanent magnet 17" having an integral cylindrical shape, a third permanent magnet 13" and a fourth permanent magnet 14'' formed of a semicircular columnar body having a semicircular transverse cross-sectional shape are arranged in a hollow center portion of the cylindrical permanent magnet 17", a fifth permanent magnet 15" having a semicircular shape is arranged along an outer peripheral surface of the third permanent magnet 13", and a sixth permanent magnet 16" having a semicircular shape may be arranged along an outer peripheral surface of the fourth permanent magnet 14''.

Also in this case, it is desirable that the integral cylindrical permanent magnet 17'' is magnetized along the reference direction, the directions of magnetization of the third permanent magnet 13 and the fourth permanent magnet 14 respectively make an angle α of 10.8° with respect to the reference direction, the direction of magnetization of the fifth permanent magnet 15" is directed toward a target region T side, and the direction of magnetization of the sixth permanent magnet 16" is directed in the direction opposite to the direction of magnetization of the fifth permanent magnet 15''.

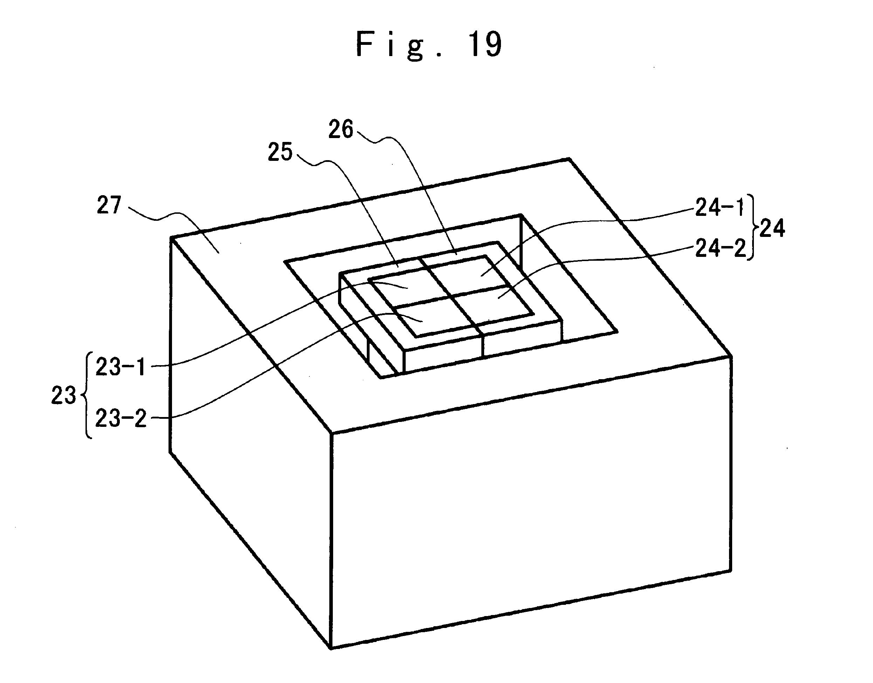

Further, as a modification of this embodiment, as shown in Fig. 19, the magnetic field generator may use a quadrangular cylindrical permanent magnet 27 in place of the cylindrical permanent magnet 17''.

Further, a third permanent magnet 23 and a fourth permanent magnet 24 which respectively have a rectangular parallelepiped shape may be arranged in a hollow center portion of the quadrangular cylindrical permanent magnet 27, a fifth permanent magnet 25 which is bent in a U shape along an outer peripheral surface of the third permanent magnet 23 may be arranged on an outer peripheral surface of the third permanent magnet 23, and a sixth permanent magnet 26 which is bent in a U shape along an outer peripheral surface of the fourth permanent magnet 24 may be arranged on an outer peripheral surface of the fourth permanent magnet 24.

Particularly, the third permanent magnet 23 is constituted of two permanent magnets 23-1, 23-2 which are arranged in a mirror symmetry with respect to a symmetry plane parallel to the reference direction, and the fourth permanent magnet 24 is constituted of two permanent magnets 24-1, 24-2 which are arranged in a mirror symmetry with respect to a symmetry plane parallel to the reference direction. In this embodiment, a contact surface between two permanent magnets 23-1, 23-2 which constitute the third permanent magnet 23, and a contact surface between two permanent magnets 24-1, 24-2 which constitute the fourth permanent magnet 24 respectively form the symmetry planes. It is not always necessary that two permanent magnets 23-1, 23-2 which constitute the third permanent magnet 23 are brought into contact with each other on the contact surface, and a predetermined distance may be provided between two permanent magnets 23-1, 23-2. In the same manner, it is not always necessary that two permanent magnets 24-1, 24-2 which constitute the fourth permanent magnet 24 are brought into contact with each other on the contact surface, and a predetermined distance may be provided between two permanent magnets 24-1, 24-2.

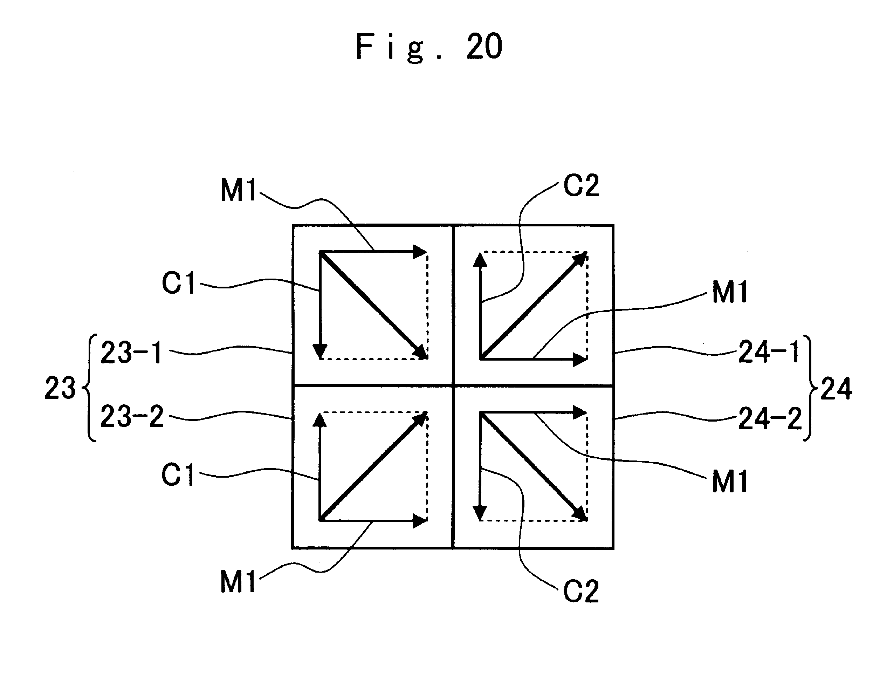

Two permanent magnets 23-1, 23-2 which constitute the third permanent magnet 23, as shown in Fig. 20 which is a plan view of the third permanent magnet 23 and the fourth permanent magnet 24, include a magnetization component which constitutes a first component M1 which is directed in the direction parallel to the reference direction and a magnetization component which constitutes a first orthogonal component C1 which is directed in the direction orthogonal to the symmetry plane and also is directed toward the symmetry plane.

Two permanent magnets 24-1, 24-2 which constitute the fourth permanent magnet 24, as shown in Fig. 20 which is the plan view of the third permanent magnet 23 and the fourth permanent magnet 24, include a magnetization component which constitutes a first component M1 which is directed in the direction parallel to the reference direction and a magnetization component which constitutes a second orthogonal component C2 which is directed in the direction orthogonal to the symmetry plane and also is directed in the direction opposite to the symmetry plane.

In this manner, by constituting the third permanent magnet 23 using two permanent magnets 23-1, 23-2 and by constituting the fourth permanent magnet 24 using two permanent magnets 24-1, 24-2, the uniformity in the target region can be enhanced.

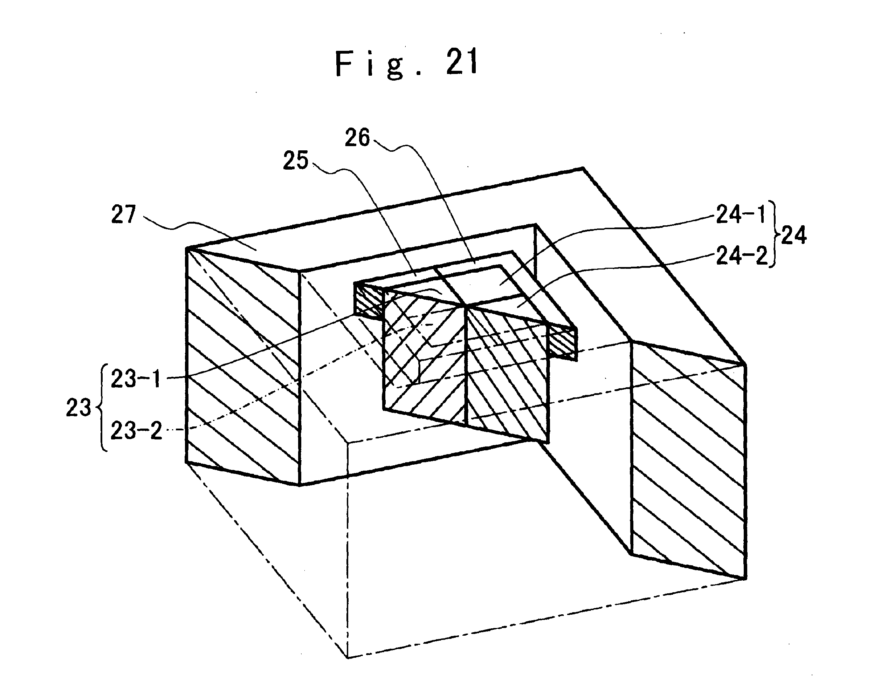

Here, it is desirable that the quadrangular cylindrical permanent magnet 27 is magnetized in the reference direction, the directions of magnetization of the third permanent magnet 13 and the fourth permanent magnet 14 respectively make an angle α of 10.8° with respect to the reference direction, the direction of magnetization of the fifth permanent magnet 25 is directed toward a target region side, and the direction of magnetization of the sixth permanent magnet 26 is directed in the direction opposite to the direction of magnetization of the fifth permanent magnet 25. Further, as shown in Fig. 21, it is desirable that the directions of magnetization of the respective permanent magnets 23, 24, 25, 26, and 27 on a cross section which passes the center of the quadrangular cylindrical permanent magnet 27 are directed in the same directions as the directions of magnetization of the respective permanent magnets 11, 12, 13, 14, 15, and 16 shown in Fig. 5.

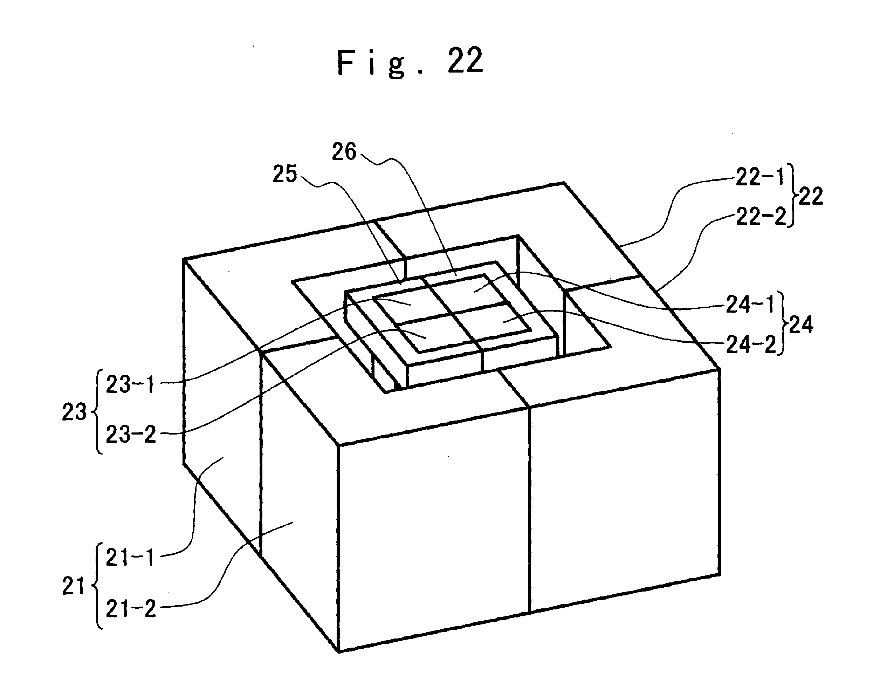

Further, in place of the quadrangular cylindrical permanent magnet 27, as shown in Fig. 22, a first permanent magnet 21 may be constituted of two permanent magnets 21-1, 21-2 which are arranged in a mirror symmetry with respect to a symmetry plane parallel to the reference direction, a second permanent magnet 22 may be constituted of two permanent magnets 22-1, 22-2 which are arranged in a mirror symmetry with respect to the symmetry plane, two permanent magnets 21-1, 21-2 which constitute the first permanent magnet 21 may have magnetic components which are respectively directed in the direction orthogonal to the symmetry plane and are directed toward the symmetry plane, and two permanent magnets 22-1, 22-2 which constitute the second permanent magnet 22 may have magnetic components which are respectively directed in the direction orthogonal to the symmetry plane and are directed in the direction opposite to the symmetry plane.

By constituting the first permanent magnet 21 using two permanent magnets 21-1, 21-2 and by constituting the second permanent magnet 22 using two permanent magnets 22-1, 22-2, the permanent magnet can be miniaturized thus realizing the reduction of a manufacturing cost.

In the above-mentioned magnetic field generator A2, it is not always necessary to bring the third to sixth permanent magnets 13 to 16 into contact with the surface of the casing 10 opposite to the main surface 10a, and the third to sixth permanent magnets 13 to 16 may be spaced apart from the surface of the casing 10 opposite to the main surface 10a by a predetermined distance. Particularly, when the magnetic field generator A2 is used as a nuclear magnetic resonance device, by providing a reception coil or a transmission coil of the nuclear magnetic resonance device between the third to sixth permanent magnets 13 to 16 which are spaced apart from the surface of the casing 10 opposite to the main surface 10a and the main surface 10a, the nuclear magnetic resonance device can be made in a compact shape.

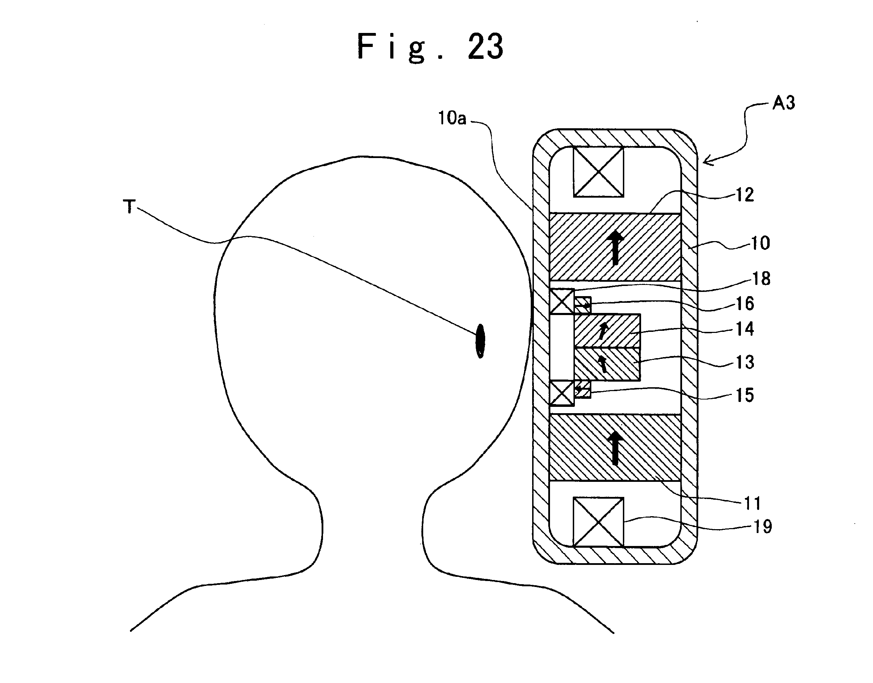

That is, in a magnetic field generator A3 for a nuclear magnetic resonance device shown in Fig. 23, by arranging the reception coil 18 between the surface of the casing 10 opposite to the main surface 10a and the third to sixth permanent magnets 13 to 16 and by arranging the transmission coil 19 in the inside of the casing 10, the nuclear magnetic resonance device is formed in a more compact shape. The magnetic field generator A3 is mounted on a stand not shown in the drawing.

The magnetic field generator A3 can form the target region T having the uniform magnetic flux density using six or four permanent magnets and hence, it is possible to provide a relatively light-weighted magnetic field generator, and the magnetic field generator A3 can be used in a state that the magnetic field generator A3 is mounted on the relatively simple stand whereby it is possible to provide a nuclear magnetic resonance device which can be manufactured at a low cost and exhibits favorable handling property.

Further, a magnetic field which is generated by the magnetic field generator A3 exhibits the magnetic flux density directed in the direction parallel to the main surface 10a and hence, it is possible to enhance detection sensitivity of a signal in the nuclear magnetic resonance device.

### Industrial applicability

According to the magnetic field generator and the nuclear magnetic resonance device which includes such a magnetic field generator of the present invention, it is possible to provide the magnetic field generator which has the magnetic circuit of an open magnetic path and can form the region having the more uniform and stable magnetic flux density and hence, by applying the magnetic field generator to the nuclear magnetic resonance device, it is possible to provide the nuclear magnetic resonance device which exhibits high detection accuracy of a predetermined signal thus realizing the inspection of high accuracy.

Particularly, the magnetic field generator can be formed in a compact shape and hence, the magnetic field generator can be manufactured at a low cost and, at the same time, portability of the magnetic field generator can be enhanced. Accordingly, a magnetic field generator can be used not only in the observation of a part relatively close to a surface of a body such as an eye, an ear, a nose, a tooth or the like but also in a non-destructive inspection of a structural body such as a concrete structural body or in an inspection carried out underground. Particularly, the magnetic field generator can detect a plastic-made mine so that the magnetic field generator can detect an object which cannot be detected by a conventional metal detector.

## Claims

1. A magnetic field generator of an open magnetic path type which is configured to form a region having magnetic flux density of a uniform magnitude at a predetermined position away from a surface of a casing using a plurality of permanent magnets housed in the casing, the magnetic field generator comprising:
a first permanent magnet and a second permanent magnet which direct directions of magnetization in a reference direction opposite to a direction of the magnetic flux density in the region, and are sequentially arranged in the reference direction with a predetermined distance therebetween; and
a third permanent magnet and a fourth permanent magnet which are sequentially arranged between the first permanent magnet and the second permanent magnet in a state that the third permanent magnet and the fourth permanent magnet are brought into contact with each other or are arranged with a predetermined distance therebetween along the reference direction, wherein
a direction of magnetization of the third permanent magnet is set to a direction having a first component which is directed parallel to the reference direction and a second component which is directed toward the region side orthogonal to the first direction, and
a direction of magnetization of the fourth permanent magnet is set to a direction having the first component and an inverted second component having a magnitude equal to a magnitude of the second component in a direction opposite to a direction of the second component.

2. A magnetic field generator according to claim 1, wherein the third permanent magnet and the fourth permanent magnet are respectively formed of a permanent magnet which includes a non-magnetic-material region where no magnetic material is present, and is configured to adjust apparent residual magnetic flux density by adjusting a size of the non-magnetic-material region and, thereafter, by magnetizing the magnetic material with saturated residual magnetic flux density by an external magnetic field having a predetermined intensity.

3. A magnetic field generator according to claim 2, wherein the adjustment of size of the non-magnetic region is the adjustment of at least any one of size, number and depth of holes or slits formed in the permanent magnet.

4. A magnetic field generator according to claim 2, wherein the adjustment of size of the non-magnetic region is the adjustment of a mixing ratio of a plurality of lump permanent magnets having a sufficiently small size compared to a volume of the third permanent magnet and a volume of the fourth permanent magnet and a non-magnetic material in a permanent magnet which is formed by mixing the plurality of permanent magnets and the non-magnetic material and by forming the lump permanent magnets and the non-magnetic material into an integral body having a predetermined shape.

5. A magnetic field generator according to claim 2, wherein the adjustment of size of the non-magnetic region is the adjustment of a content ratio of a plurality of permanent magnet blocks and a plurality of non-magnetic-material blocks having the same shape as the permanent magnet blocks in a permanent magnet which is formed by integrally bonding the permanent magnet blocks and the non-magnetic-material blocks.

6. A magnetic field generator according to any one of claims 1 to 5, wherein the first permanent magnet and the second permanent magnet are integrally formed by one cylindrical permanent magnet having a cylindrical shape,
two pieces of third permanent magnets and two pieces of fourth permanent magnets are respectively arranged in a hollow center portion of the cylindrical permanent magnet in such a state that said two pieces of the third permanent magnets and said two pieces of said fourth permanent magnets are respectively arranged in a mirror symmetry with respect to a symmetry plane which passes the center of the cylindrical permanent magnet and is parallel to the reference direction,
a first inner permanent magnet is mounted on a symmetry surface side of the third permanent magnets respectively, and a first outer permanent magnet is mounted on a side opposite to the first inner permanent magnet with the third permanent magnet sandwiched therebetween respectively,
a second inner permanent magnet is mounted on a symmetry surface side of the fourth permanent magnets respectively, and a second outer permanent magnet is mounted on a side opposite to the second inner permanent magnet with the fourth permanent magnet sandwiched therebetween respectively, and
a direction of magnetization of the first inner permanent magnet is directed in the direction of the second component, a direction of magnetization of the first outer permanent magnet is directed in a direction opposite to the direction of the second component, a direction of magnetization of the second inner permanent magnet is directed in a direction opposite to the direction of the second component, and a direction of magnetization of the second outer permanent magnet is directed in a direction of the second component.

7. A magnetic field generator according to claim 2, wherein a fifth permanent magnet is arranged between the first permanent magnet and the third permanent magnet, and a direction of magnetization of the fifth permanent magnet is directed in a combined direction of a third component parallel to or antiparallel to the reference direction and a fourth component which is directed toward a region side orthogonal to the reference direction, and
a sixth permanent magnet is arranged between the second permanent magnet and the fourth permanent magnet, and a direction of magnetization of the sixth permanent magnet is directed in a combined direction of the third component and an inverted fourth component which is directed in a direction opposite to a direction of the fourth component and has the same magnitude as the fourth component.

8. A magnetic field generator according to claim 2, wherein a fifth permanent magnet which has a direction of magnetization thereof directed in the direction parallel to the second component is arranged between the first permanent magnet and the third permanent magnet, and
a sixth permanent magnet which has a direction of magnetization thereof directed in the direction parallel to the inverted second component is arranged between the second permanent magnet and the fourth permanent magnet.

9. A magnetic field generator according to claim 7 or claim 8, wherein the first permanent magnet and the second permanent magnet are integrally formed from one cylindrical permanent magnet having a cylindrical shape, and
the third permanent magnet and the fourth permanent magnet are respectively arranged in a hollow center portion of the cylindrical permanent magnet.

10. A magnetic field generator according to claim 7 or claim 8, wherein the first permanent magnet is constituted of two permanent magnets which are arranged in a mirror symmetry with respect to a symmetry plane parallel to the reference direction, and said two permanent magnets respectively include a magnetization component which is directed in a direction orthogonal to the symmetry plane and toward the symmetry plane, and
the second permanent magnet is constituted of two permanent magnets which are arranged in a mirror symmetry with respect to the symmetry plane, and said two permanent magnets respectively include a magnetization component which is directed in a direction orthogonal to the symmetry plane and in a direction opposite to the symmetry plane.

11. A magnetic field generator according to claim 9 or claim 10, wherein the third permanent magnet is constituted of two permanent magnets which are arranged in a mirror symmetry with respect to a symmetry plane parallel to the reference direction, and said two permanent magnets respectively include a magnetization component which is directed in a direction orthogonal to the symmetry plane and toward the symmetry plane, and
the fourth permanent magnet is constituted of two permanent magnets which are arranged in a mirror symmetry with respect to the symmetry plane, and said two permanent magnets respectively include a magnetization component which is directed in a direction orthogonal to the symmetry plane and in a direction opposite to the symmetry plane.

12. A nuclear magnetic resonance device provided with the magnetic field generator of any one of claims 1 to 11.
